# EUROPEAN PATENT SPECIFICATION

(11) **EP 2 246 461 B1**
(45) Date of publication and mention of the grant of the patent: **20.03.2013**
(21) Application number: 08864615.3
(22) Date of filing: 17.12.2008
(51) Int. Cl.: C30B 13/24

(54) **FLOATING-ZONE MELTING APPARATUS**
VORRICHTUNG ZUM SCHWEBEZONENSCHMELZEN
APPAREIL DE FUSION À ZONE FLOTTANTE

(30) Priority: 25.12.2007 JP 2007332559
(43) Date of publication of application: 03.11.2010
(73) Proprietor: CRYSTAL SYSTEMS CORPORATION, Yamanashi 408-0044 (JP)
(72) Inventor: SHINDO, Isamu, Hokuto-shi Yamanashi 408-0041 (JP)
(74) Representative: Hall, Matthew Benjamin
(86) International application number: PCT/JP2008/072957
(87) International publication number: WO 2009/081811

(56) References cited:
- EP-A2- 0 106 547
- EP-A2- 0 864 669
- WO-A1-86/04619
- DE-A1- 2 813 760
- JP-A- 4 130 082
- JP-A- 4 367 585
- JP-A- 5 043 378
- JP-A- 6 234 509
- JP-A- 8 208 368
- JP-A- 8 231 292
- JP-A- 11 092 271
- JP-A- 11 092 271
- JP-A- 49 093 280
- JP-A- 55 090 498
- JP-A- 57 106 596
- JP-A- 2002 362 997
- JP-A- 2005 247 668
- JP-A- 2007 099 602
- JP-A- 2007 099 602
- JP-A- 2007 145 611
- JP-A- 2009 173 485
- JP-B- 49 014 010
- JP-Y- 47 029 047
- JP-Y- 47 029 047
- US-A- 4 602 980
- KIMURA H ET AL: "Crystal growth of Ba(B1-xAlx)2O4 using a new Fz furnace with double ring-shaped halogen lamp heater", JOURNAL OF CRYSTAL GROWTH, ELSEVIER, AMSTERDAM, NL, vol. 212, no. 1-2, 1 January 2000 (2000-01-01), pages 364-367, XP004196245, ISSN: 0022-0248, DOI: DOI:10.1016/S0022-0248(00)00008-7

## Description

### TECHNICAL FIELD

The present invention relates to a floating zone melting apparatus of the infrared concentration heating type in which a part of a sample in a rod shape for instance is irradiated with an infrared ray to heat and melt the sample, and the molten sample is solidified on a seed crystal or the like to grow a single crystal in a rod shape.

### BACKGROUND ART

To produce a single crystal, an infrared lamp unit is prepared in which an infrared lamp such as a halogen lamp and a xenon lamp is disposed at one focal point of an ellipsoidal reflecting mirror (hereafter referred to as an elliptical mirror), infrared rays emitted from the infrared lamp unit are converged to the other focal point, a local heating of a solid sample (a sample in a rod shape for instance) that has been disposed at the location is carried out to melt and deposit the solid sample. The above method is called a floating zone melting method. A great number of floating zone melting apparatuses that adopt the floating zone melting method and application examples thereof have been reported.

For the floating zone melting method, since a sample can be molten and deposited without using a container such as a skull crucible, a contamination caused by a skull crucible material can be prevented. In addition, the dissolution and a deposition of a sample in a rod shape (a sample in a rod shape is also hereafter referred to as a sample rod) can be carried out in a successive manner. Consequently, a single crystal having a uniform composition can be grown from a sample rod that has been prepared to have a uniform composition by the extremely excellent method.

On the other hand, a method that is almost exclusively used industrially for growing a single crystal is a pull method. In this method, a material is set in a skull crucible made of a noble metal such as platinum and iridium and is molten, a seed crystal is then dipped in the molten sample and is plumped, and the seed crystal is pulled up to grow a single crystal of a large size.

However, the pull method is provided with disadvantages in which a skull crucible material is incorporated into a crystal as an impurity and a concentration of an additive material is not uniform.

In the case in which a single crystal of a large size can be grown by the above described floating zone melting method, the floating zone melting method is provided with the following advantages and is a predominantly advantageous method industrially.
(1) Since a skull crucible is not used, a cost can be lowered.
(2) Since a contamination caused by a skull crucible material can be prevented, a single crystal product of a high purity can be produced.
(3) A single crystal having a uniform composition can be grown by using a raw material having a uniform composition.

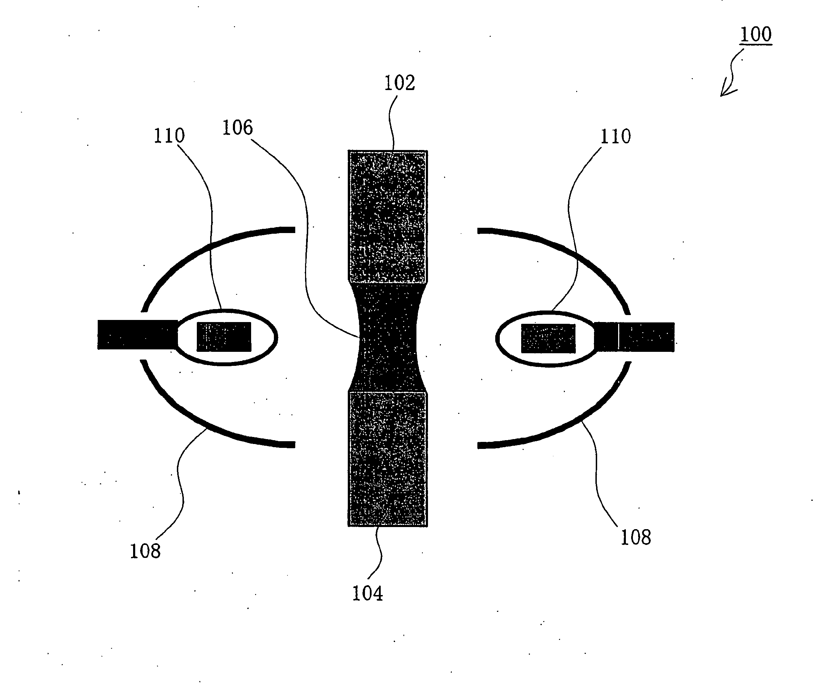

A floating zone melting apparatus of a twin elliptical mirror type in which the above described floating zone melting method is adopted will be described in the following with reference to a conceptual diagram shown in Fig. 8.

In the floating zone melting apparatus 100 of a twin elliptical mirror type, an elliptical mirror 108 is disposed on the left side of a sample 102 in a rod shape and an elliptical mirror 108 is disposed on the right side of a sample 102 in a rod shape. Lights that are emitted from an infrared lamp 110 that has been disposed at a focal point of the elliptical mirror 108 are converged to the center point in which the second focal points thereof are shared in such a manner that the sample 102 in a rod shape is molten at the center point. The dissolution and a deposition of the sample 102 in a rod shape are then carried out in a successive manner to grow a single crystal. A numeral 106 represents a molten part and a numeral 104 represents a grown crystal.

For the floating zone melting apparatus 100, the parts in the front and back directions in the figure are not irradiated with lights. Consequently, in the case in which a temperature detection terminal is set to the surface of the sample 102 in a rod shape having a diameter of 10 mm for instance and a temperature distribution of a molten part of the sample 102 in a rod shape is measured without rotating the sample 102 in a rod shape, a part that is facing the infrared lamp 110 (in the right and left direction in the figure) and a part in a direction perpendicular to the right and left direction (in the front and back direction in the figure) are greatly different in a temperature. As a result, uniform dissolution and deposition are difficult disadvantageously.

To make up for this disadvantage, infrared lamps are set in the front and back directions of the floating zone melting apparatus 100 of a twin elliptical mirror type and total four elliptical mirrors are used to develop a new floating zone melting apparatus of a quadruple elliptical mirror type (not shown) (see Patent document 1 for instance).

This floating zone melting apparatus is dramatically improved in a temperature distribution in a horizontal direction and enables a single crystal of a good quality to be grown as compared with the floating zone melting apparatus 100 of a twin elliptical mirror type.

However, even by using the floating zone melting apparatus of a quadruple elliptical mirror type, a single crystal having a diameter of up to 1 inch can only be formed, which is sufficient for a research. It is extremely hard to grow a single crystal having a diameter larger than 4 inches (approximately 100 mm) which is industrially required even by using the floating zone melting apparatus of a quadruple elliptical mirror type.

One of the biggest reasons is in the following. That is, in the case in which a sample is molten by an infrared ray, an infrared ray is absorbed into the sample. Consequently, as an absorption progresses from the surface, an intensity (or a quantity) of an infrared ray is reduced. Even in the case in which a large amount of molten solutions is tried to be formed, it is difficult for an infrared ray to reach the center position of the sample, and a temperature of the center part is not increased, whereby it is difficult to form a large amount of molten solutions and a single crystal having a large diameter cannot be formed.

Moreover, even in the case in which a large amount of molten solutions can be formed by the conventional method, the molten solutions are dropped and cannot be held in a stable manner, whereby a single crystal cannot be formed in a stable manner.

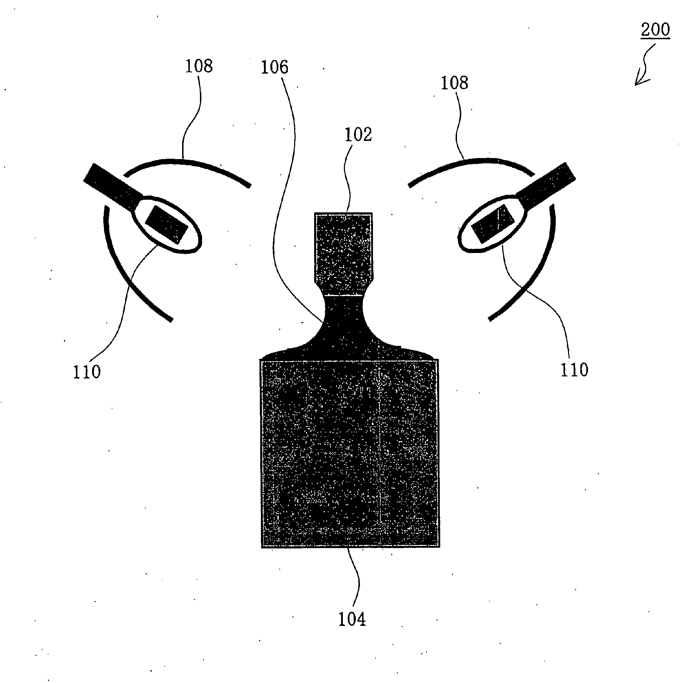

Consequently, as shown in Fig. 9, a floating zone melting apparatus 200 of an oblique quadruple elliptical mirror type has been developed in which four elliptical mirrors 108 are disposed in an oblique direction and the sample 102 in a rod shape is irradiated with an infrared ray from an oblique upper direction. By this configuration, while the dropping of molten solutions is suppressed, a large amount of molten solutions is formed and a single crystal having a large diameter can be formed (see Patent document 2 for instance).
Patent document 1: Japanese Patent Application Laid-Open Publication No. 9-235171
Patent document 2: Japanese Patent Application Laid-Open Publication No. 2007-99602
JP 2007 099602 discloses a floating zone melting apparatus of a four elliptical mirror type comprising a rotary ellipsoidal reflecting mirror disposed opposite to each other on an orthogonal axis.

### DISCLOSURE OF THE INVENTION

### PROBLEMS TO BE SOLVED BY THE INVENTION

However, in the case in which the floating zone melting apparatus 200 of an oblique quadruple elliptical mirror type is used to carry out a growth of a single crystal as a practical matter, although it is easy to hold a large amount of molten solutions by an irradiation of an infrared ray from an oblique upper direction (to grow a single crystal having a large diameter without dropping molten solutions), it is hard to melt the sample 102 in a rod shape in many cases.

Moreover, in the case in which a large amount of molten solutions with a high melting point is formed by using only the infrared lamp 110, a load of the infrared lamp 110 is extremely large in some cases. In other words, in order to increase an output power of the infrared lamp 110, it is thought that a temperature of a filament must be increased or a size of a filament must be increased. However, an increase in a temperature of a filament is limited, and even in the case in which a size of a filament is increased, a size of a light concentration part is enlarged, whereby an effect of increasing a temperature of molten solutions is small disadvantageously.

Consequently, it is required that a new floating zone melting apparatus is developed for solving the above problems.

The present invention was made in consideration of such conditions, and an object of the present invention is to provide a floating zone melting apparatus in which a sample rod especially having a large diameter can be stably molten with a certainty and the single crystal being grown can retain a flat shape at the interface of the solid phase and the liquid phase, whereby a single crystal having a large diameter can be grown.

Another object of the present invention is to provide a floating zone melting apparatus in which a single crystal having a large diameter can be formed in effect by reducing a load of an infrared lamp to the greatest extent possible.

### MEANS FOR SOLVING THE PROBLEMS

The present invention was made in order to solve the above described problems of the conventional art and to achieve the purpose. A floating zone melting apparatus in accordance with the present invention is a floating zone melting apparatus of the infrared concentration heating type in which a sample is set in a sample chamber made of a transparent quartz tube, an atmospheric gas is introduced into the sample chamber, infrared rays emitted from a plurality of infrared ray irradiation means are converged to the sample to heat and melt the sample in this state, thereby obtaining a molten solution, and the molten solution is solidified on a seed crystal to grow a single crystal,
the plurality of infrared ray irradiation means is characterized by comprising:
a plurality of infrared ray irradiation means of the downward irradiation type that emit an infrared ray downward from an oblique upper direction; and
a plurality of infrared ray irradiation means of the upward irradiation type that emit an infrared ray upward from an oblique lower direction, wherein the plurality of infrared ray irradiation means of the downward irradiation type and the plurality of infrared ray irradiation means of the upward irradiation type are disposed at regular intervals around an axis of the sample as a center, and the positions of the infrared ray irradiation means are shifted from each other in such a manner that a single infrared ray irradiation means of the upward irradiation type is located in a gap of the plurality of infrared ray irradiation means of the downward irradiation type disposed at regular intervals in the case in which infrared ray irradiation means of two stages are viewed from directly above.

As described above, infrared rays are emitted in the two directions downward from an upper side and upward from a lower side. A control of the interface of the solid phase and the liquid phase for a grown crystal is carried out by an irradiation of an infrared ray emitted downward from an upper side, and a sample can be efficiently molten in a stable manner by an irradiation of an infrared ray emitted upward from a lower side. Consequently, even a sample having a large diameter can be heated and molten with a certainty, and a single crystal having a large diameter can be grown in a stable manner by controlling a shape of the interface of the solid phase and the liquid phase for a large amount of molten solutions that have been formed and a grown crystal.

As described above, in the case in which each of the infrared ray irradiation means of the upward irradiation type disposed at the lower stage is located in each gap of the infrared ray irradiation means of the downward irradiation type disposed at regular intervals, angles between dispositions of the infrared ray irradiation means can be approximate to each other, and the total light concentration efficiency can be improved.

A floating zone melting apparatus in accordance with the present invention may be characterized in that the infrared ray irradiation means is an infrared lamp unit comprising a rotary ellipsoidal reflecting mirror in which an inner face is used as a reflecting face and an infrared lamp disposed at one focal point thereof.

As described above, in the case in which the infrared ray irradiation means is an infrared lamp unit, infrared rays of a required irradiation amount can be efficiently generated, and the infrared ray irradiation means can be used repeatedly by replacing an infrared lamp, whereby a production cost can be suppressed.

A floating zone melting apparatus in accordance with the present invention may be characterized in that the infrared ray irradiation means is a laser oscillator that is configured to emit an infrared ray by a laser beam.

As described above, in the case in which the infrared ray irradiation means is a laser oscillator, it is not necessary to use a rotary ellipsoidal reflecting mirror unlike the above infrared lamp unit due to a high directive property, and a pinpoint of a sample can be molten with a certainty for instance, whereby a large amount of molten solutions can be obtained in a stable manner.

A floating zone melting apparatus in accordance with the present invention may be characterized in that the infrared ray irradiation means of the downward irradiation type and the infrared ray irradiation means of the upward irradiation type are configured to enable a position control thereof independently.

As described above, in the case in which each of the rotary ellipsoidal reflecting mirrors that have been disposed in an upper direction and a lower direction can be independently controlled, a diameter and a growth rate of a single crystal can be adjusted by controlling a degree of heating and melting a sample. Moreover, in the case in which each of the rotary ellipsoidal reflecting mirrors is controlled for instance, a shape of a single crystal that is grown can be adjusted, thereby enabling a growth of a single crystal of a good quality having a large diameter and having a shape such as a cylindrical shape and a prismatic column shape.

A floating zone melting apparatus in accordance with the present invention may be characterized in that the infrared ray irradiation means of the downward irradiation type and the infrared ray irradiation means of the upward irradiation type are provided with an irradiation position control mechanism that is configured to independently adjust an irradiation angle and an irradiation amount of infrared rays.

As described above, in the case in which the floating zone melting apparatus is provided with a mechanism for controlling an irradiation position and an irradiation amount, a control of a shape of the interface of the solid phase and the liquid phase for a grown crystal can be carried out while controlling a melting state corresponding to a material quality and a state of a sample, whereby a single crystal having a large diameter can be grown in a stable manner.

A floating zone melting apparatus in accordance with the present invention may be characterized in that the infrared ray irradiation means is provided with a horizontal position control mechanism for a horizontal movement in an irradiation direction from a position in which the sample is disposed as a center.

As described above, in the case in which the floating zone melting apparatus is provided with a horizontal position control mechanism, a focal point can be easily set to a most appropriate position corresponding to a thickness of a sample, an optical absorption property of a sample, and a degree of a diameter of a single crystal that is grown. Therefore, a single crystal can be grown in a stable manner in a most appropriate optical layout corresponding to a diameter of a single crystal.

A floating zone melting apparatus in accordance with the present invention may be characterized in that a sample heating means in a tube shape is disposed in such a manner that a periphery of the sample is enclosed.

By the above configuration, a temperature of a sample rod can be maintained to be high in advance, and a single crystal can be grown in a stable manner as compared with the case in which a sample rod with a high melting point is molten by only the infrared ray irradiation means.

Moreover, even in the case in which the sample heating means in a tube shape is irradiated with an infrared ray, the sample heating means in a tube shape absorbs the infrared ray and the infrared ray does not reach the sample.

In a conventional art, since a sample rod is irradiated with an infrared ray at an angle and the dissolution makes progress at a dull pace, the discontinuous dissolution easily occurs, thereby causing a composition variation, and it is hard to grow a single crystal having a uniform composition disadvantageously. The present invention can suppress the above problems by the above configuration, and enables a single crystal having a high quality to be grown.

A floating zone melting apparatus in accordance with the present invention may be characterized by further comprising a position control mechanism that is configured to control a position of the sample heating means.

As described above, in the case in which a position of the sample heating means can be controlled, the sample heating means can be moved corresponding to a molten point of a sample rod, whereby only a desired point of a sample rod can be irradiated with an infrared ray on a constant basis to melt the sample rod.

A floating zone melting apparatus in accordance with the present invention may be characterized in that a crystal heating means in a tube shape is disposed in such a manner that a periphery of the grown crystal is enclosed.

By the above configuration, an amount of heat for maintaining a temperature around the interface of the solid phase and the liquid phase of a single crystal to be high does not depend on only the infrared ray irradiation means, and a temperature around the interface of the solid phase and the liquid phase of a single crystal can be maintained to be high by compensating an amount of heat that is required for growing a single crystal with an amount of heat from the crystal heating means, whereby a single crystal having a large diameter can be grown.

A floating zone melting apparatus in accordance with the present invention may be characterized by further comprising a position control mechanism that is configured to control a position of the crystal heating means.

As described above, in the case in which a position of the crystal heating means can be controlled, as well as the crystal heating means can be moved corresponding to a degree of growing a single crystal, an infrared ray that is emitted upward from a lower side can be shielded by the crystal heating means as needed. Consequently, a control of the interface of the solid phase and the liquid phase on a grown crystal side can be easily carried out, whereby a single crystal of a good quality having a large diameter can be grown.

A floating zone melting apparatus in accordance with the present invention may be characterized by further comprising a mechanism in which a shielding member that is configured to limit an irradiation amount of infrared rays that are emitted from the infrared ray irradiation means is disposed around the sample and the grown crystal and in which a synchronization is enabled with a rotation and a movement of the grown crystal.

By the above configuration, even in the case of a material that can be easily oblate and that is hard to have a large diameter for a growth of a single crystal, an irradiation amount of infrared rays from a constant direction can be limited on a constant basis by rotating and moving the shielding member in synchronization with a grown crystal corresponding to an orientation of a growth of a single crystal. Consequently, a single crystal can be grown to be in a shape such as a cylindrical shape and a prismatic column shape, whereby a single crystal having a large diameter can be grown.

A floating zone melting apparatus in accordance with the present invention may be characterized in that an introduction gas pipe made of transparent quartz that is configured to efficiently eject a vaporized material that is generated in heating and melting the sample together with the atmospheric gas outside the sample chamber is disposed between an inner wall of the sample chamber and the sample.

By the above configuration, since a vaporized material that is generated in heating and melting the sample can be efficiently ejected together with the atmospheric gas outside the sample chamber, a deposit substance generated by a vaporized material dose not adhere to an inner wall of the sample chamber made of transparent quartz pipe, whereby a single crystal can be grown in a stable manner.

Moreover, since the introduction gas pipe is disposed and a gap between the introduction gas pipe and a sample or a sample support part in a shaft shape can be small at a level in which a problem does not occur in a normal use, a rate of flow of the atmospheric gas that passes through the introduction gas pipe can be increased in comparison even in the case in which a supply quantity of the atmospheric gas is not increased so much.

As a result, fine particles caused by a vaporized material generated from a molten part are ejected outside the sample chamber together with the atmospheric gas at a staggering rate of speed. Consequently, as well as a vaporized material can be prevented from adhering to an inner wall of the sample chamber made of transparent quartz pipe, a vaporized material can be prevented from adhering to the introduction gas pipe, thereby enabling a stable use for a long period of time.

Furthermore, since the introduction gas pipe is made of transparent quartz, a single crystal can be grown while a lower section of the introduction gas pipe is made to be close to a molten part without shielding infrared rays that are emitted from the infrared ray irradiation means, an effect of ejecting a vaporized material can be further improved.

A floating zone melting apparatus in accordance with the present invention may be characterized in that a diameter of a shape of an end part that is located on the side of heating and melting the sample for the introduction gas pipe is larger than that of other parts.

That is, as a gap between an inner diameter of the introduction gas pipe and a thickness of a sample or a sample support part in a shaft shape for supporting a sample is smaller, a rate of flow of the atmospheric gas can be increased and an effect of ejecting a vaporized material can be further improved advantageously. However, as an inner diameter of the introduction gas pipe is smaller, an effect of introducing a vaporized material is smaller disadvantageously.

To make up for this disadvantage, it is extremely effective to add a vaporized material accumulation pipe having a diameter larger than other sections to a leading end of the introduction gas pipe in order to maximize an introducing effect of a vaporized material while keeping an inner diameter of the introduction gas pipe to be requisite minimum as far as possible.

Almost all of vaporized materials that are generated in heating and melting a sample rod can be introduced into the introduction gas pipe and ejected outside the sample chamber by forming the introduction gas pipe in such a shape and disposing a lower section of the introduction gas pipe close to a molten part.

As a result, an amount of a deposit substance that is stored in the sample chamber and that adheres to an inner wall of the sample chamber made of a transparent quartz pipe can be extremely small.

Therefore, even in the case in which a single crystal growth of a substance that is easily vaporized is carried out for a long period of time, a deposit substance is not practically found on an inner wall of a transparent quartz pipe, whereby a single crystal can be grown in a stable manner for a long period of time.

A floating zone melting apparatus in accordance with the present invention may be characterized in that an atmospheric gas can be introduced in such a manner that a rate of flow of the atmospheric gas that passes through the introduction gas pipe is at least 10 cm per second.

That is, a vaporized material that is vaporized from a molten part in the ordinary course of events is flown to the upper side by a convection current caused by a heat and is diffused to adhere to an inner wall of an environmental transparent quartz pipe.

At this time, in the case in which a quantity of flow and a rate of flow of the atmospheric gas are large, the vaporized material is ejected together with the atmospheric gas outside the sample chamber.

As a result, in the case in which an atmospheric gas is introduced in such a manner that a rate of flow of the atmospheric gas that passes through the introduction gas pipe is at least 10 cm per second, an adherence of a deposit substance to an inner wall of the transparent quartz pipe can be effectively suppressed.

A floating zone melting apparatus in accordance with the present invention may be characterized by further comprising a circulation device that is configured to supply an atmospheric gas that has been ejected from the sample chamber again into the sample chamber.

As described above, in the case in which the floating zone melting apparatus is provided with a circulation device, a costly atmospheric gas can be used without a waste, whereby a cost for growing a single crystal can be suppressed.

A floating zone melting apparatus in accordance with the present invention may be characterized in that the circulation device is configured to separate a vaporized material that is generated in heating and melting the sample and that is ejected together with the atmospheric gas by using a filter member in such a manner that only the atmospheric gas is supplied into the sample chamber.

By the above circulation device, the vaporized material can be ejected together with the atmospheric gas outside the sample chamber, and only an atmospheric gas from which the vaporized material has been separated by using a filter member can be circulated. Consequently, an inner wall of a sample chamber made of a quartz pipe can be maintained to be clean on a constant basis, and a growth of a single crystal can be continued in a stable manner.

### EFFECT OF THE INVENTION

In accordance with the present invention, a plurality of infrared ray irradiation means are disposed at two stages in such a manner that a sample is irradiated with infrared ray from two directions of an upper direction and a lower direction, and an irradiation angle and an irradiation amount of infrared rays of the infrared ray irradiation means are controlled corresponding to an actual melting property while independently controlling the infrared ray irradiation means disposed at two stages. Consequently, there can be proposed a floating zone melting apparatus in which a single crystal having a large diameter can be grown as intended by using a sample rod having a large diameter

Moreover, by disposing a sample heating means and a crystal heating means, there can be proposed a floating zone melting apparatus in which a load of the infrared ray irradiation means can be reduced..

### BRIEF DESCRIPTION OF THE DRAWINGS

Fig. 1 is a schematic view showing a first embodiment of a floating zone melting apparatus in which an infrared lamp unit of the downward irradiation type and an infrared lamp unit of the upward irradiation type are used in accordance with of the present invention.
Fig. 2 is a schematic view showing a second embodiment of a floating zone melting apparatus in which an infrared lamp unit of the downward irradiation type and an infrared lamp unit of the upward irradiation type are used in accordance with of the present invention.
Fig. 3 is a schematic view showing a third embodiment of a floating zone melting apparatus in which an infrared lamp unit of the downward irradiation type and an infrared lamp unit of the upward irradiation type are used in accordance with of the present invention.
Fig. 4 is a top view showing the floating zone melting apparatus shown in Fig. 3, and Figs. 4(a) and 4(b) are schematic views showing an embodiment of a shielding member.
Fig. 5 is a schematic view showing a fourth embodiment of a floating zone melting apparatus in which an infrared lamp unit of the downward irradiation type and an infrared lamp unit of the upward irradiation type are used in accordance with of the present invention.
Fig. 6 is a schematic view showing a state in which a diameter of a shape of an end part of an introduction gas pipe in accordance with the fourth embodiment is enlarged as compared with other sections.
Fig. 7 is a schematic view showing a fifth embodiment of a floating zone melting apparatus in which an infrared lamp unit of the downward irradiation type and an infrared lamp unit of the upward irradiation type are used in accordance with of the present invention.
Fig. 8 is an explanatory diagram showing a conventional floating zone melting apparatus of a quadruple elliptical mirror type in which an elliptical mirror is disposed on one side and on the other side of a sample in a rod shape and a sample is irradiated with an infrared ray in a horizontal direction.
Fig. 9 is an explanatory diagram showing a conventional floating zone melting apparatus of an oblique quadruple elliptical mirror type in which four elliptical mirrors are disposed in an oblique direction and a sample is irradiated with an infrared ray from an oblique upper direction.

### EXPLANATIONS OF LETTERS OR NUMERALS

10a: Floating zone melting apparatus
10b: Floating zone melting apparatus
10c: Floating zone melting apparatus
10d: Floating zone melting apparatus
12: Sample rod
14: Grown crystal
16: Molten part
18: Rotary ellipsoidal reflecting mirror (elliptical mirror)
20: Infrared lamp
21: Infrared lamp unit
21a: Infrared lamp unit
21b: Infrared lamp unit
22: Sample heating means
24: Crystal heating means
26: Shielding member
26a: Shielding member
26b: Shielding member
28: Drive part
30: Sample chamber
32: Atmospheric gas
34: Introduction gas pipe
36: Circulation device
38: Filter member
100: Floating zone melting apparatus of a twin elliptical mirror type
102: Sample in a rod shape
104: Grown crystal
106: Molten part
108: Elliptical mirror
110: Infrared lamp
200: Floating zone melting apparatus of an oblique elliptical mirror type

### BEST MODE OF CARRYING OUT THE INVENTION

An embodiment (example) of the present invention will be described below in detail with reference to the drawings.

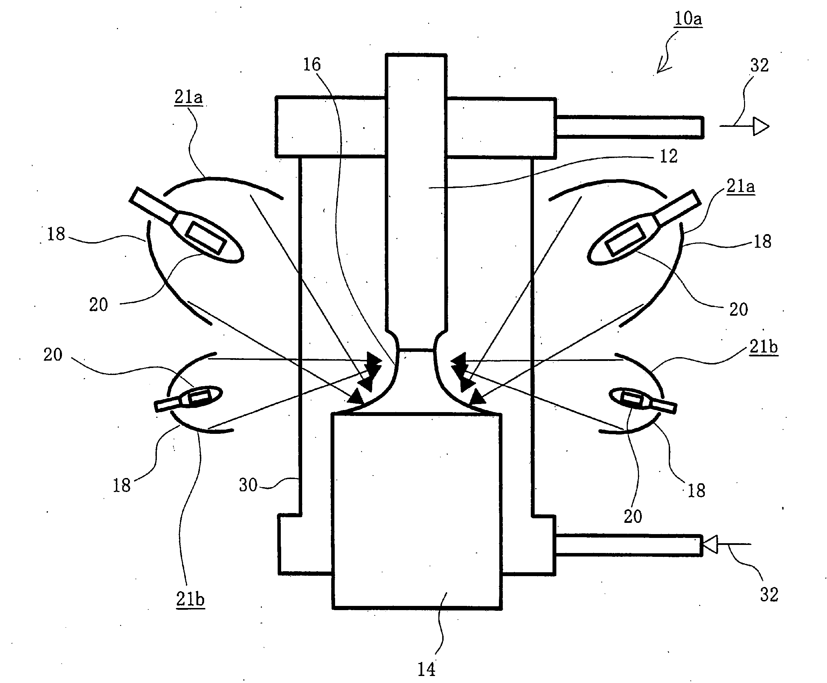

Fig. 1 is a schematic view showing a first embodiment of a floating zone melting apparatus in which an infrared ray irradiation means of the downward irradiation type and an infrared ray irradiation means of the upward irradiation type are used in accordance with of the present invention. For the floating zone melting apparatus, an infrared lamp unit is used as the infrared ray irradiation means.

For the floating zone melting apparatus in accordance with of the present invention, a part of a sample in a rod shape for instance is irradiated with an infrared ray to heat and melt the sample, and the molten sample is solidified on a seed crystal or the like to grow a single crystal in a rod shape.

The "downward" of the downward irradiation type that is used in the present specification indicates the range of 0° to 90° on the basis of the horizontal line. The "upward" of the upward irradiation type that is used in the present specification indicates the range of 0° to -90° on the basis of the horizontal line.

The "seed crystal" that is used in the present specification indicates a first mode of a crystal in the case in which a single crystal having a large diameter is grown by using a floating zone melting apparatus. The "grown crystal" that is used in the present specification indicates a single crystal that is being grown.

As shown in Fig. 1, for the configuration of a floating zone melting apparatus 10a in accordance with of the present invention, a sample rod 12 is disposed in a sample chamber 30 made of a transparent quartz tube, an atmospheric gas 32 is introduced into the sample chamber 30, infrared rays emitted from a plurality of infrared lamp units 21 are converged to the sample rod 12 to heat and melt the sample rod 12 in this state, thereby obtaining a molten solution, and the molten solution is solidified on a seed crystal to grow a single crystal.

The plurality of infrared lamp units 21 are composed of a rotary ellipsoidal reflecting mirror 18 (hereafter referred to as an elliptical mirror 18) and an infrared lamp 20, and the plurality of infrared lamp units 21 are disposed in such a manner that a periphery of the sample rod 12 is enclosed.

The infrared lamp units 21 share the focal point thereof with each other at the center position in which the sample rod 12 is disposed.

The infrared lamp 20 is disposed at a focal point on the side opposite to a light concentration side of each of the elliptical mirrors 18 of the infrared lamp units 21. Infrared rays that have been emitted from the filament of the infrared lamp 20 are reflected from the elliptical mirrors 18 and converged to the other focal point to heat the sample rod 12.

An infrared lamp such as a halogen lamp and a xenon lamp can be used as the infrared lamp 20.

The plurality of infrared lamp units 21 that are configured as described above are composed of an infrared lamp unit 21a of the downward irradiation type that is disposed in such a manner that a straight line from one focal point to the other focal point is slanted downward and an infrared lamp unit 21b of the upward irradiation type that is disposed in such a manner that a straight line from one focal point to the other focal point is slanted upward.

The infrared lamp unit 21a of the downward irradiation type is disposed in such a manner that the sample rod 12 is irradiated from an oblique upper direction with an infrared ray that has been reflected from the reflecting surface of the elliptical mirrors 18. It is preferable that the number of the infrared lamp units 21a of the downward irradiation type that are disposed is at least four. However, the number of the infrared lamp units 21a is not restricted in particular, and modifications can be made as needed.

On the other hand, the infrared lamp unit 21b of the upward irradiation type is disposed in such a manner that the sample rod 12 is irradiated from an oblique lower direction with an infrared ray that has been reflected from the reflecting surface of the elliptical mirrors 18. It is also preferable that the number of the infrared lamp units 21b of the upward irradiation type that are disposed is at least four. However, the number of the infrared lamp units 21b is not restricted in particular.

The infrared lamp unit 21a of the downward irradiation type and the infrared lamp unit 21b of the upward irradiation type are disposed at regular intervals around an axis of the sample rod 12 as a center. In the present embodiment, four infrared lamp units 21a are disposed at a regular interval of 90 degrees, and four infrared lamp units 21b are disposed at a regular interval of 90 degrees.

The infrared lamp unit 21a of the downward irradiation type and the infrared lamp unit 21b of the upward irradiation type are provided with an irradiation position control mechanism (not shown) that is configured to independently adjust an irradiation angle and an irradiation amount of infrared rays. By this configuration, the infrared lamp units 21a of the downward irradiation type and the infrared lamp units 21b of the upward irradiation type can be disposed at a desired location corresponding to a size and a material of the sample rod 12 and an irradiation angle and an irradiation amount of infrared rays that are emitted to the sample rod 12.

Moreover, in addition to the irradiation position control mechanism, the infrared lamp units are also provided with a horizontal position control mechanism (not shown) for a horizontal movement in an irradiation direction from a position in which the sample rod 12 is disposed as a center. By the two types of the position control mechanisms, the infrared lamp units 21a of the downward irradiation type and the infrared lamp units 21b of the upward irradiation type can be disposed at a desired location.

By the above position control mechanisms, a single crystal growing part and a molten part 16 of the sample rod 12 are irradiated with an infrared ray that has been reflected from the reflecting surface of the elliptical mirrors 18 of the infrared lamp unit 21a of the downward irradiation type and the infrared lamp unit 21b of the upward irradiation type from an oblique upper direction and an oblique lower direction, respectively. Consequently, a shape of the interface of the solid phase and the liquid phase for a grown crystal 14 and the molten part 16 can be stabilized even in the case in which a diameter of a single crystal is large.

For the infrared lamp unit 21a of the downward irradiation type in particular, a molten solution generated by melting the sample rod 12 can be prevented from being dropped from the upper side of the grown crystal 14 by controlling an irradiation amount and an irradiation position of the infrared lamp 20. In other words, a crystal can be grown to be a single crystal having a large diameter by controlling the state of the interface of the solid phase and the liquid phase for the grown crystal 14 with the above position control mechanisms on a constant basis.

Moreover, for the infrared lamp unit 21b of the upward irradiation type in particular, a large amount of molten solutions can be obtained in a stable manner while specializing in a molten solution of the sample rod 12 by irradiating the molten part 16 of the sample rod 12 with an infrared ray in particular.

By independently controlling the infrared lamp unit 21a of the downward irradiation type and the infrared lamp unit 21b of the upward irradiation type, a single crystal having a large diameter of approximately 100 mm for instance from the sample rod 12 having a large diameter. The infrared lamp unit 21a of the downward irradiation type and the infrared lamp unit 21b of the upward irradiation type can be independently controlled by separately setting a conventionally known control device for instance.

In the present embodiment, four infrared lamp units 21a of the downward irradiation type and four infrared lamp units 21b of the upward irradiation type are used for the configuration. However, the number of infrared lamp units is not restricted, and six infrared lamp units 21a of the downward irradiation type and six infrared lamp units 21b of the upward irradiation type can also be used for instance. For a disposition angle of the infrared lamp units 21a of the downward irradiation type and the infrared lamp units 21b of the upward irradiation type, it is preferable that the infrared lamp units are disposed at an interval of 90 degrees in the case of four infrared lamp units and the infrared lamp units are disposed at an interval of 60 degrees in the case of six infrared lamp units.

Moreover, in the case in which the infrared lamp unit 21b of the upward irradiation type located on the lower stage is disposed in a gap between adjacent infrared lamp units 21a of the downward irradiation type, angles between the infrared lamp units can be approximate to each other, whereby the total light concentration efficiency can be improved.

For a disposal angle of the infrared lamp unit 21a of the downward irradiation type and the infrared lamp unit 21b of the upward irradiation type, a disposal angle of the infrared lamp unit 21a of the downward irradiation type can be in the range of 0° to 90° on the basis of the horizontal line and a disposal angle of the infrared lamp unit 21b of the upward irradiation type can be in the range of 0° to -90° on the basis of the horizontal line as described above although it is not restricted in particular. It is more preferable that a disposal angle of the infrared lamp unit 21a of the downward irradiation type is in the range of 25 to 35° on the basis of the horizontal line and a disposal angle of the infrared lamp unit 21b of the upward irradiation type is in the range of 0° to -5° on the basis of the horizontal line.

In the case in which the infrared lamp unit 21a of the downward irradiation type and the infrared lamp unit 21b of the upward irradiation type are disposed at such an angle, the molten solutions can be easily held, a single crystal can be grown in a stable manner, a phenomenon in which the dissolution of a sample makes progress at a dull pace can be suppressed, the interface of the solid phase and the liquid phase can be stabilized, and a single crystal of a high quality can be easily grown.

Moreover, for a material, a shape, and a production method of the elliptical mirrors 18 that is applied in the infrared lamp unit 21a of the downward irradiation type and the infrared lamp unit 21b of the upward irradiation type, conventionally known material, shape, and production method that are described in Patent document 2 can be adopted for instance.

A method for growing a single crystal by the floating zone melting apparatus 10a above described will be described in the following.

A sample chamber 30 made of a quartz pipe is formed in the floating zone melting apparatus 10a as shown in Fig. 1, and the sample rod 12 is held in the sample chamber 30. Moreover, the floating zone melting apparatus 10a is provided with a pressure control means and an atmospheric control means. By this configuration, the sample chamber 30 can be in a vacuum state, and an atmospheric gas 32 can be flown through the sample chamber 30.

The sample rod 12 is disposed in a vertical direction in the sample chamber 30 made of a quartz pipe in such a manner that the sample rod 12 passes through a focal point on a light concentration side. The upper end side of the sample rod 12 is supported by a sample rod supporting part (not shown) formed in a shaft shape.

On the other hand, the lower end side of a seed crystal that is used for growing the growth crystal 14 is supported by a growth crystal supporting part (not shown) formed in a shaft shape.

Each of the supporting parts can be moved in a vertical direction and can be rotated around an axis of the sample rod 12 by using a driving device via a drive part that has been mounted to the supporting part.

The above members are held in a container. An operator carries out the operations such as a position control of the elliptical mirrors 18 of the infrared lamp unit 21a of the downward irradiation type and the infrared lamp unit 21b of the upward irradiation type and a voltage control of the infrared lamp 20.

A CCD camera that is used for taking an image of a molten region is installed in the container. An operator observes a molten region and controls a voltage that is applied to the infrared lamp 20.

The infrared lamp 20 and the elliptical mirror 18 of the infrared lamp unit 21a of the downward irradiation type and the infrared lamp unit 21b of the upward irradiation type are cooled by an air flow caused by a fan for instance.

In the case in which a growth of a single crystal is started, the end part of the sample rod 12 that is supported by a sample rod supporting part and the end part of the seed crystal that is supported by a growth crystal supporting part are disposed opposite to each other, and the sample chamber 30 made of a quartz pipe is disposed. The infrared lamp 20 is then lighted, and a voltage that is applied to the infrared lamp 20 is increased by slow degrees while the sample rod 12 and the seed crystal are rotated, whereby each of the end parts thereof is molten.

At the stage in which the both end parts are molten, the end part of the sample rod 12 and the end part of the seed crystal are moved closer to each other, and the molten parts are made to be coalescent. At this time, both of the sample rod 12 and the seed crystal are rotated, and a voltage that is applied to the infrared lamp 20 is controlled, whereby a size of the molten part 16 can be controlled and a stable molten region can be formed.

After a stable molten region is formed, the sample rod 12 and the seed crystal are moved downward at the same speed or at different speeds in which a lowering speed of the sample rod 12 is higher than that of the seed crystal (in the range of 0.1 to 100 mm/h for instance) by the driving device. Consequently, the sample rod 12 is molten and a crystal is grown continuously, whereby a growth of a single crystal formed in a rod shape is carried out.

As described above, for the floating zone melting apparatus 10a in accordance with the present embodiment, the infrared lamp unit 21a of the downward irradiation type can concentrate on making a shape of the interface of the solid phase and the liquid phase to be a shape that is most suitable for growing a single crystal of a high quality, and the infrared lamp unit 21b of the upward irradiation type can concentrate on melting the sample rod 12.

In other words, the infrared lamp units are disposed at two different locations, and the infrared lamp unit 21a of the downward irradiation type and the infrared lamp unit 21b of the upward irradiation type play different roles from each other, whereby a single crystal of a high quality having a large diameter can be grown in a stable manner.

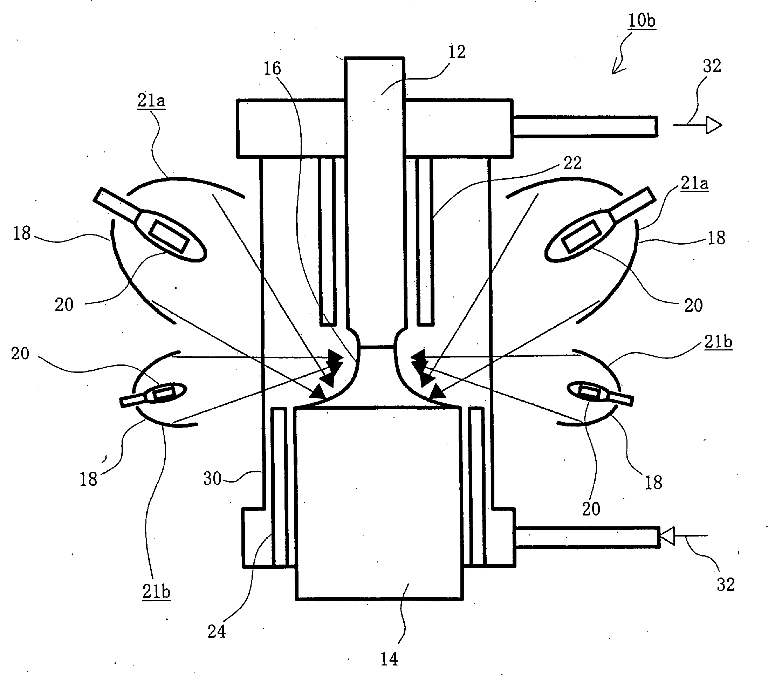

A second embodiment of the floating zone melting apparatus in accordance with the present embodiment will be described below in detail with reference to the schematic view shown in Fig. 2.

The configuration of the floating zone melting apparatus 10b shown in Fig. 2 is equivalent to that of the floating zone melting apparatus 10a shown in Fig. 1 in the elementary sense. Consequently, elements equivalent to those illustrated in Fig. 1 are numerically numbered similarly in Fig. 2 and the detailed descriptions of the equivalent elements are omitted.

The floating zone melting apparatus 10b shown in Fig. 2 is different from the floating zone melting apparatus 10a shown in Fig. 1 in terms of that a sample heating means 22 in a tube shape is disposed in such a manner that a periphery of the sample rod 12 is enclosed and a crystal heating means 24 in a tube shape is disposed in such a manner that a periphery of the grown crystal 14 is enclosed.

By the floating zone melting apparatus 10b provided with the above configuration, a temperature of a sample rod 12 can be maintained to be high in advance by operating the sample heating means 22, and a single crystal can be grown in a stable manner as compared with the case in which a sample rod 12 with a high melting point is molten by only the infrared lamp 20.

Moreover, since a section other than the molten part 16 of the sample rod 12 is covered by the sample heating means 22, an irradiation amount of infrared rays caused by the infrared lamp 20 is reduced to the section other than the molten part 16, and only a desired section of the sample rod 12 can be molten.

In a conventional art, since a sample rod 12 is irradiated with an infrared ray at an angle and the dissolution makes progress at a dull pace, the discontinuous dissolution easily occurs, thereby causing a composition variation, and it is hard to grow a single crystal having a uniform composition disadvantageously. The present invention can suppress the above problems by the above configuration, and enables a single crystal having a high quality to be grown.

Moreover, by the crystal heating means 24, an amount of heat for maintaining a temperature around the interface of the solid phase and the liquid phase of a single crystal to be high does not depend on only the infrared lamp 20, and a temperature around the interface of the solid phase and the liquid phase of a single crystal can be maintained to be high by compensating an amount of heat that is required for growing a single crystal with an amount of heat from the crystal heating means 24.

Moreover, the sample heating means 22 and the crystal heating means 24 are provided with a position control mechanism (not shown) that is configured to control a position corresponding to a molten state of the sample rod 12 and a shape of the grown crystal 14.

The sample heating means 22 and the crystal heating means 24 can have any configuration providing the sample heating means 22 and the crystal heating means 24 can heat the sample rod 12 and the grown crystal 14. In consideration of a use at a high temperature, it is preferable to use the sample heating means 22 and the crystal heating means 24 made of a material such as a silicon carbide electrical heating element, a platinum wire, and a rhodium addition platinum wire. '

As described above, in the case in which the floating zone melting apparatus 10a shown in Fig. 1 is further provided with the sample heating means 22 and the crystal heating means 24, a single crystal of a higher quality having a larger diameter can be grown.

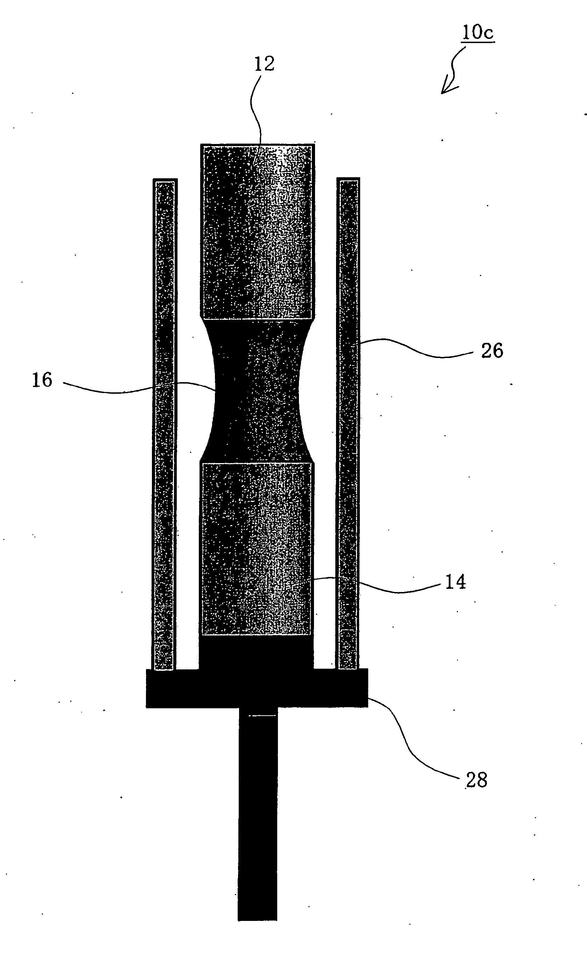

A third embodiment of the floating zone melting apparatus in accordance with the present embodiment will be described below in detail with reference to the schematic view shown in Fig. 3.

The configuration of the floating zone melting apparatus 10c shown in Fig. 3 is equivalent to that of the floating zone melting apparatus 10a shown in Fig. 1 in the elementary sense. Consequently, elements equivalent to those illustrated in Fig. 1 are numerically numbered similarly in Fig. 3 and the detailed descriptions of the equivalent elements are omitted.

The floating zone melting apparatus 10c shown in Fig. 3 is different from the floating zone melting apparatus 10a shown in Fig. 1 in terms of that a shielding member 26 that is configured to limit an irradiation amount of infrared rays that are emitted from the infrared lamp 20 is disposed around the sample rod 12 and the grown crystal 14.

By the floating zone melting apparatus 10c provided with the above configuration, a shielding member 26 is disposed around the sample rod 12 and the grown crystal 14, thereby limiting an irradiation amount of infrared rays that are emitted from the infrared lamp 20.

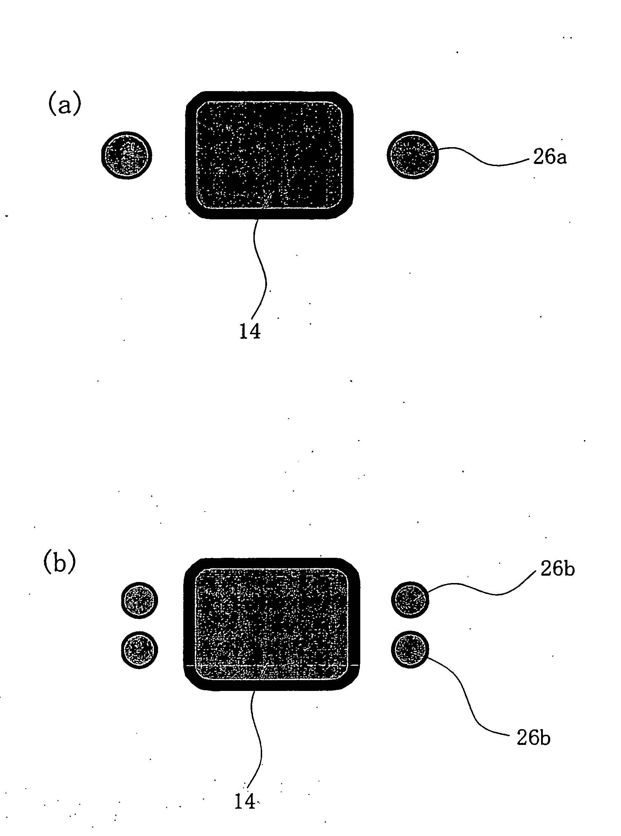

The shielding member 26 can be in any shape providing the shielding member 26 can limit an irradiation amount of infrared rays. However, as shown in Fig.4 (a) and 4 (b) for instance it is preferable to dispose the shielding members 26a and 26b in a rod shape around the grown crystal 14 as needed.

As described above, by disposing the shielding member 26, even in the case of a material that can be easily oblate and that is hard to have a large diameter for a growth of a single crystal, an irradiation amount of infrared rays from a constant direction can be limited on a constant basis by rotating the shielding member 26 in synchronization with the grown crystal 14 via a drive part 28 of a driving device (not shown) corresponding to an orientation of a growth of a single crystal.

Consequently, a single crystal can be grown to be in a shape such as a cylindrical shape and a prismatic column shape, whereby a single crystal having a large diameter can be grown.

A material of the shielding member 26 is not restricted in particular. However, in consideration of a use at a high temperature, it is preferable to use the shielding member 26 provided with an alumina quality or a mullite quality.

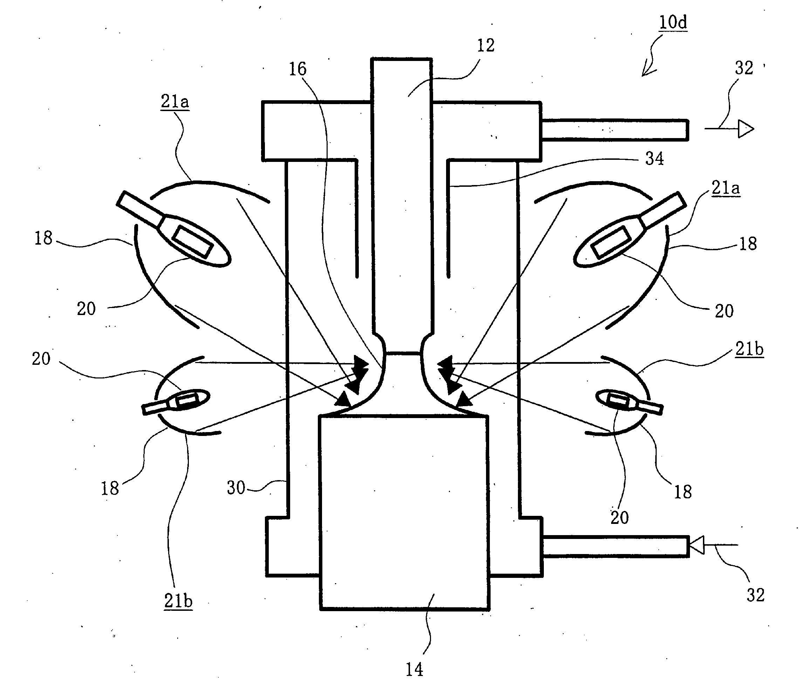

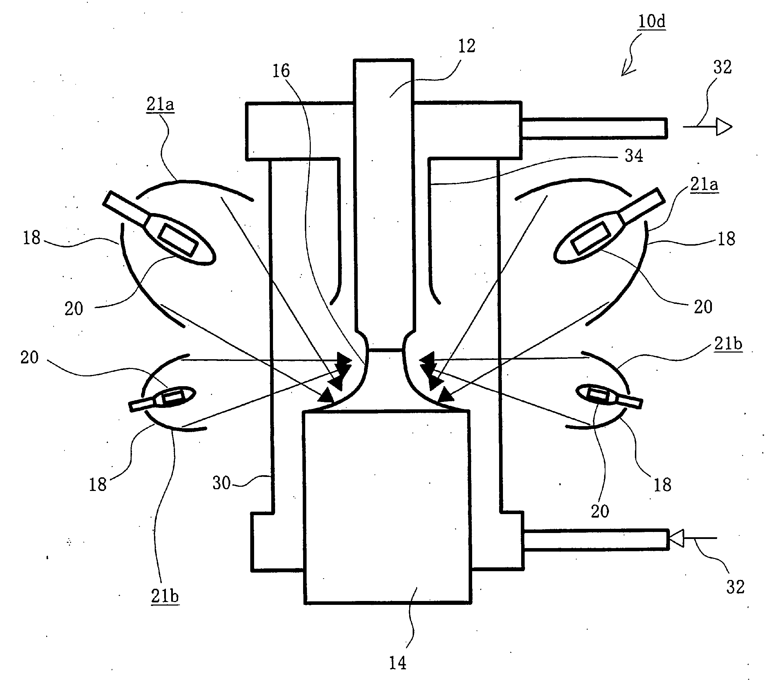

A fourth embodiment of the floating zone melting apparatus in accordance with the present embodiment will be described below in detail with reference to the schematic views shown in Fig. 5 and Fig. 6.

The configuration of the floating zone melting apparatus 10d shown in Fig. 5 and Fig. 6 is equivalent to that of the floating zone melting apparatus 10a shown in Fig. 1 in the elementary sense. Consequently, elements equivalent to those illustrated in Fig. 1 are numerically numbered similarly in Fig. 5 and Fig. 6 and the detailed descriptions of the equivalent elements are omitted.

The floating zone melting apparatus 10d shown in Fig. 5 and Fig. 6 is different from the floating zone melting apparatus 10a shown in Fig. 1 in terms of that an introduction gas pipe 34 made of transparent quartz is disposed between the inner wall of the sample chamber 30 and the sample rod 12.

As described above, by disposing the introduction gas pipe 34, a vaporized material that is generated in heating and melting the sample rod 12 can be efficiently ejected together with the atmospheric gas 32 outside the sample chamber 30.

A shape of the introduction gas pipe 34 shown in Fig. 5 is straight. As a gap between an inner diameter of the introduction gas pipe 34 and the sample rod 12 is smaller, a rate of flow of the atmospheric gas 32 can be increased and an effect of ejecting a vaporized material can be further improved advantageously. However, as an inner diameter of the introduction gas pipe 34 is smaller, an effect of introducing a vaporized material is smaller disadvantageously.

Consequently, in the case in which an inner diameter of the introduction gas pipe 34 is small, for the introduction gas pipe 34 as shown in Fig. 6, a diameter of a shape of an end part of the introduction gas pipe 34 is made larger than that of other parts. As a result, an introducing effect of a vaporized material can be satisfactory while keeping an inner diameter of the introduction gas pipe 34 to be requisite minimum as far as possible.

Moreover, it is preferable that a rate of flow of the atmospheric gas 32 that passes through the introduction gas pipe 34 is specified to be at least 10 cm per second.

That is, a vaporized material that is vaporized from a molten part 16 in the ordinary course of events is flown to the upper side by a convection current caused by a heat and is diffused to adhere to an inner wall of the sample chamber 30 made of a transparent quartz pipe conventionally. However, in the case in which a rate of flow of the atmospheric gas 32 is specified as described above, a vaporized material can be efficiently ejected together with the atmospheric gas 32 outside the sample chamber 30.

As a result, an adherence of a deposit substance to an inner wall of the sample chamber 30 can be effectively suppressed.

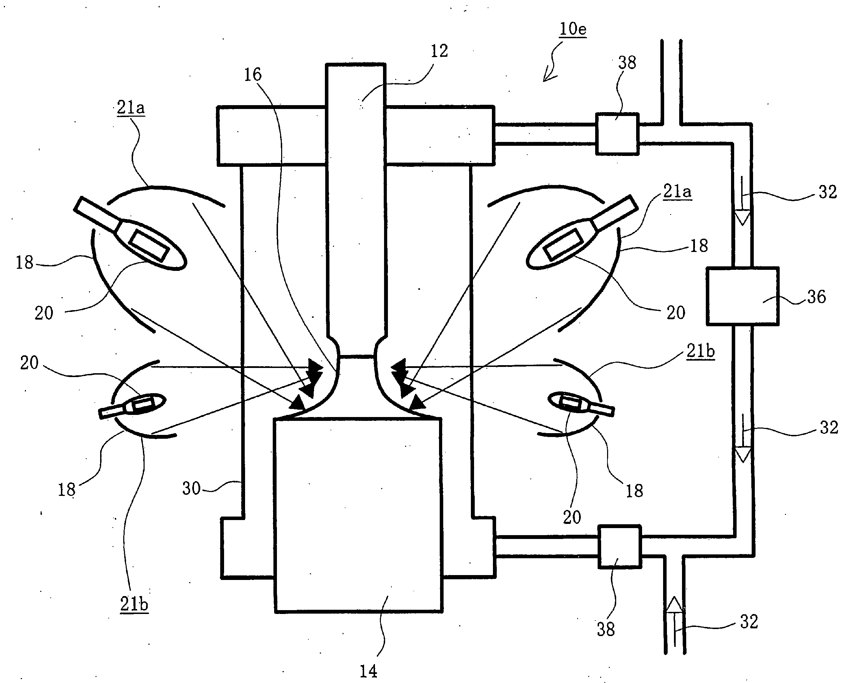

A fifth embodiment of the floating zone melting apparatus in accordance with the present embodiment will be described below in detail with reference to the schematic view shown in Fig. 7.

The configuration of the floating zone melting apparatus 10e shown in Fig. 7 is equivalent to that of the floating zone melting apparatus 10a shown in Fig. 1 in the elementary sense. Consequently, elements equivalent to those illustrated in Fig. 1 are numerically numbered similarly in Fig. 7 and the detailed descriptions of the equivalent elements are omitted.

The floating zone melting apparatus 10e shown in Fig. 7 is different from the floating zone melting apparatus 10a shown in Fig, 1 in terms of that a circulation device 36 is disposed to be configured to supply an atmospheric gas 32 that has been ejected from the sample chamber 30 again into the sample chamber 30.

The circulation device 36 is configured to separate a vaporized material that is generated in heating and melting the sample rod 12 and that is ejected together with the atmospheric gas 32 by using a filter member 38 in such a manner that only the atmospheric gas 32 can be supplied into the sample chamber 30.

As described above, in the case in which the floating zone melting apparatus is provided with the circulation device 36, a costly atmospheric gas 32 can be used without a waste, whereby a cost for growing a single crystal can be suppressed.

By the above circulation device, the vaporized material can be ejected together with the atmospheric gas 32 outside the sample chamber, and only an atmospheric gas 32 from which the vaporized material has been separated by using the filter member 38 can be circulated. Consequently, an inner wall of the sample chamber 30 made of a transparent quartz pipe can be maintained to be clean on a constant basis, and a growth of a single crystal can be continued in a stable manner.

For the first embodiment to the fifth embodiment described above, an example has been described in which an infrared lamp unit 21 composed of an elliptical mirror 18 and an infrared lamp 20 is used as the infrared ray irradiation means. However, a laser oscillator (not shown) that is configured to emit an infrared ray can also be used as the infrared ray irradiation means.

In the case in which a laser oscillator is used as the infrared ray irradiation means, since a laser beam has a high directive property, when a laser beam that has been emitted from a laser oscillator of the downward irradiation type is reflected by a molten solution and a laser oscillator of the upward irradiation type that is located at the lower stage is irradiated with the reflected laser beam for instance, there is a possibility that the laser oscillator of the upward irradiation type located at the lower stage is damaged.

However, in the case in which a laser oscillator of the downward irradiation type and a laser oscillator of the upward irradiation type are disposed in such a manner that the positions are shifted from each other by 90 degrees (in the case in which four laser oscillators are disposed) or 60 degrees (in the case in which six laser oscillators are disposed) for instance depending on the number of laser oscillators similarly to a disposal method of the infrared lamp unit as described above, the laser oscillator can be prevented from being damaged and can be preferably used for the floating zone melting apparatus in accordance with the present invention.

For a disposal angle of a laser oscillator of the downward irradiation type and a laser oscillator of the upward irradiation type similarly to the infrared lamp units 21a and 21b described above, a disposal angle of a laser oscillator of the downward irradiation type can be in the range of 0° to 90° on the basis of the horizontal line and a disposal angle of a laser oscillator of the upward irradiation type can be in the range of 0° to -90° on the basis of the horizontal line although it is not restricted in particular. It is more preferable that a disposal angle of a laser oscillator of the downward irradiation type is in the range of 25° to 35° on the basis of the horizontal line and a disposal angle of a laser oscillator of the upward irradiation type is in the range of 0° to -5° on the basis of the horizontal line.

In the case in which a laser oscillator of the downward irradiation type and a laser oscillator of the upward irradiation type are disposed at such an angle, the molten solutions can be easily held, a single crystal can be grown in a stable manner, a phenomenon in which the dissolution of a sample makes progress at a dull pace can be suppressed, the interface of the solid phase and the liquid phase can be stabilized, and a single crystal of a high quality can be easily grown.

While the preferred embodiments in accordance with the present invention have been described above, the present invention is not restricted to the embodiments. For instance, the configuration in which the second embodiment and the third embodiment are combined with each other or the configuration in which the fourth embodiment and the fifth embodiment are combined with each other can also be adopted.

Moreover, it is preferable that four infrared ray irradiation means of the downward irradiation type and four infrared ray irradiation means of the upward irradiation type are disposed or six infrared ray irradiation means of the downward irradiation type and six infrared ray irradiation means of the upward irradiation type are disposed. However, it is not necessary that the number of infrared ray irradiation means of the downward irradiation type is equivalent to that of infrared ray irradiation means of the upward irradiation type. For instance, four infrared ray irradiation means of the downward irradiation type and six infrared ray irradiation means of the upward irradiation type can also be disposed. As described above, the various changes, modifications, and functional additions can be thus made without departing from the scope of the present invention.

### [Embodiments]

While the preferred embodiments in which the floating zone melting apparatus in accordance with the present invention is adopted will be described in the following, the present invention is not restricted to the embodiments.

### [Embodiment 1]

Eight elliptical mirrors made of a quartz glass were disposed on the horizontal face in such a manner that the elliptical mirrors share one focal point thereof with each other, and a halogen lamp was disposed at the other focal point of each of the elliptical mirrors, whereby eight halogen lamp units were configured. A lamp having an output power of 1000 W in a filament shape having a double helical structure was used for each of the halogen lamps.

In such a manner that a sample rod is disposed in a vertical direction at the center position of the elliptical mirrors, a sintered sample rod having a diameter of 20 mm was supported from the upper side by a sample rod supporting part, and a seed crystal was supported from the lower side by a growth crystal supporting part.

Four halogen lamp units of the eight halogen lamp units are disposed at an interval of 90 degrees around the axis of the sample rod and at an angle of 30 degrees in such a manner that the sample in a rod shape is irradiated downward with an infrared ray from an oblique upper direction.

On the other hand, the other four halogen lamp units of the eight halogen lamp units are disposed at an interval of 90 degrees around the axis of the sample rod and at an angle of 10 degrees in such a manner that the sample in a rod shape is irradiated upward with an infrared ray from an oblique lower direction. In this case, the position of four halogen lamp units of the downward irradiation type disposed on the upper side and the position of four halogen lamp units of the upward irradiation type disposed on the lower side are shifted from each other by 45 degrees in the case in which the halogen lamp units on the upper side and the halogen lamp units on the lower side are viewed from directly above.

The end part of the sample rod and the end part of the seed crystal were then faced to each other.

After the quartz pipe was disposed around the elliptical mirror furnace that was configured by the halogen lamp units, the eight halogen lamps were lighted. A voltage that was applied to the halogen lamps was increased by slow degrees while the sample rod and the seed crystal were rotated, and each of the end parts thereof was molten.

At the stage in which the both end parts were molten, the end part of the sample rod and the end part of the seed crystal were moved closer to each other, and the molten parts were made to be coalescent. After a stable molten material was formed, while the sample rod and the seed crystal were slowly moved downward at the constant speed, a melting operation of the sample rod and a growth of the crystal were continued, whereby a growth of a single crystal in a rod shape was carried out.

A molten material was enabled to be easily held, and a single crystal of a high quality having a diameter of 55 mm was grown in a stable manner.

### [Embodiment 2]

A single crystal in a rod shape was grown under the conditions equivalent to those of Embodiment 1 except that a sample heating means in a tube shape was disposed in such a manner that a periphery of the sample rod was enclosed, a crystal heating means in a tube shape was disposed in such a manner that a periphery of the seed crystal (the grown crystal) was enclosed, the sample rod was heated by the sample heating means in advance, and the grown crystal of the seed crystal was heated by the crystal heating means in a continuous manner.

A single crystal that was grown was a single crystal of a high quality having a diameter of 80 mm.

### [Embodiment 3]

A single crystal in a rod shape was grown under the conditions equivalent to those of Embodiment 1 except that a shielding member in a rod shape was disposed around the sample rod and the seed crystal and an irradiation amount of infrared rays that are emitted from the infrared lamp was limited in a growth of a single crystal.

It was enabled that a single crystal of a high quality having a diameter of 25 mm was grown in a prismatic column shape.

### [Embodiment 4]

A single crystal in a rod shape was grown under the conditions equivalent to those of Embodiment 1 except that a laser oscillator of the downward irradiation type and a laser oscillator of the upward irradiation type were used as substitute for the halogen lamp unit of the downward irradiation type and the halogen lamp unit of the upward irradiation type.

A molten material was enabled to be easily held, and a single crystal of a high quality having a diameter of 25 mm was grown in a stable manner.

### [Comparative example 1]

A single crystal in a rod shape was grown under the conditions equivalent to those of Embodiment 1 except that only the halogen lamp unit of the downward irradiation type was used.

Although a sample rod having a diameter of 20 mm was molten to try to hold a molten material, the dissolution of a sample rod made progress at a dull pace, and the center part of the sample rod easily came into contact with a single crystal on the lower side, whereby a molten material was not formed in a stable manner and a single crystal was not grown.

## Claims

1. A floating zone melting apparatus (10a; 10b; 10c; 10d; 10e) of the infrared concentration heating type in which a sample (12) is set in a sample chamber (30) made of a transparent quartz tube, an atmospheric gas (32) is introduced into the sample chamber, infrared rays emitted from a plurality of infrared ray irradiation means (21) are converged to the sample to heat and melt the sample in this state, thereby obtaining a molten solution, and the molten solution is solidified on a seed crystal to grow a single crystal(14),
the plurality of infrared ray irradiation means comprising:
a plurality of infrared ray irradiation means (21 a) of the downward irradiation type that emit an infrared ray downward from an oblique upper direction; and
a plurality of infrared ray irradiation means (21 b) of the upward irradiation type that emit an infrared ray upward from an oblique lower direction,
wherein the plurality of infrared ray irradiation means (21 a) of the downward irradiation type and the plurality of infrared ray irradiation means (21 b) of the upward irradiation type are disposed at regular intervals around an axis of the sample (12) as a center, and
the positions of the infrared ray irradiation means are shifted from each other in such a manner that a single infrared ray irradiation means of the upward irradiation type is located in a gap of the plurality of infrared ray irradiation means of the downward irradiation type disposed at regular intervals in the case in which infrared ray irradiation means of two stages are viewed from directly above.

2. A floating zone melting apparatus as defined in claim 1, wherein the infrared ray irradiation means (21a) of the downward irradiation type and the infrared ray irradiation means (21 b) of the upward irradiation type are configured to enable a position control thereof independently.

3. A floating zone melting apparatus as defined in claim 1 or 2, wherein the infrared ray irradiation means (21) is an infrared lamp unit comprising a rotary ellipsoidal reflecting mirror (18) in which an inner face is used as a reflecting face and an infrared lamp (20) disposed at one focal point thereof.

4. A floating zone melting apparatus as defined in claim 1 or 2, wherein the infrared ray irradiation means (21) is a laser oscillator that is configured to emit an infrared ray by a laser beam.

5. A floating zone melting apparatus as defined in any one of claims 1 to 4, wherein the infrared ray irradiation means (21a) of the downward irradiation type and the infrared ray irradiation means (21 b) of the upward irradiation type are provided with an irradiation position control mechanism that is configured to independently adjust an irradiation angle and an irradiation amount of infrared rays.

6. A floating zone melting apparatus as defined in any one of claims 1 to 5, wherein the infrared ray irradiation means (21) is provided with a horizontal position control mechanism for a horizontal movement in an irradiation direction from a position in which the sample (12) is disposed as a center.

7. A floating zone melting apparatus as defined in any one of claims 1 to 6, wherein a sample heating means (22) in a tube shape is disposed in such a manner that a periphery of the sample (12) is enclosed.

8. A floating zone melting apparatus as defined in claim 7, further comprising a position control mechanism that is configured to control a position of the sample heating means (22).

9. A floating zone melting apparatus as defined in any one of claims 1 to 8, wherein a crystal heating means (24) in a tube shape is disposed in such a manner that a periphery of the grown crystal (14) is enclosed.

10. A floating zone melting apparatus as defined in claim 9, further comprising a position control mechanism that is configured to control a position of the crystal heating means (24).

11. A floating zone melting apparatus as defined in any one of claims 1 to 10, further comprising a mechanism in which a shielding member (26) that is configured to limit an irradiation amount of infrared rays that are emitted from the infrared ray irradiation means (21) is disposed around the sample(12) and the grown crystal (14) and in which a synchronization is enabled with a rotation and a movement of the grown crystal.

12. A floating zone melting apparatus as defined in any one of claims 1 to 11, wherein an introduction gas pipe (34) made of transparent quartz that is configured to efficiently eject a vaporized material that is generated in heating and melting the sample (12) together with the atmospheric gas outside the sample chamber is disposed between an inner wall of the sample chamber and the sample.

13. A floating zone melting apparatus as defined in claim 12, wherein a diameter of a shape of an end part that is located on the side of heating and melting the sample for the introduction gas pipe (34) is larger than that of other parts.

14. A floating zone melting apparatus as defined in claim 12 or 13, wherein an atmospheric gas (32) can be introduced in such a manner that a rate of flow of the atmospheric gas that passes through the introduction gas pipe (34) is at least 10 cm per second.

15. A floating zone melting apparatus as defined in any one of claims 1 to 14, further comprising a circulation device (36) that is configured to supply an atmospheric gas (32) that has been ejected from the sample chamber (30) again into the sample chamber, wherein the circulation device is preferably configured to separate a vaporized material that is generated in heating and melting the sample (12) and that is ejected together with the atmospheric gas by using a filter member (38) in such a manner that only the atmospheric gas is supplied into the sample chamber.

## Patentansprüche

1. Zonenschmelzvorrichtung (10a; 10b; 10c; 10d; 10e) vom Typ Infrarotkonzentrierungserwärmung, bei der eine Probe (12) in eine Probenkammer (30) gebracht wird, die aus einem transparenten Quarzrohr hergestellt ist, ein Atmosphärengas (32) in die Probenkammer eingeleitet wird, Infrarotstrahlen, die von mehreren Infrarotstrahlen-Bestrahlungsmitteln (21) emittiert werden, auf die Probe zum Erwärmen und Schmelzen der Probe in diesem Zustand konzentriert werden, wodurch eine geschmolzene Lösung erhalten wird, und die geschmolzene Lösung an einem Impfkristall erstarrt, um so einen Einkristall (14) zu züchten,
wobei die mehreren Infrarotstrahlen-Bestrahlungsmittel Folgendes umfassen:
mehrere Infrarotstrahlen-Bestrahlungsmittel (21 a) vom Typ der Abwärtsbestrahlung, die einen Infrarotstrahl von einer schrägen oberen Richtung nach unten emittieren; und
mehrere Infrarotstrahlen-Bestrahlungsmittel (21 b) vom Typ der Aufwärtsbestrahlung, die einen Infrarotstrahl von einer schrägen unteren Richtung nach oben emittieren,
wobei die mehreren Infrarotstrahlen-Bestrahlungsmittel (21 a) vom Typ der Abwärtsbestrahlung und die mehreren Infrarotstrahlen-Bestrahlungsmittel (21 b) vom Typ der Aufwärtsbestrahlung in regelmäßigen Abständen um eine Achse der Probe (12) als Mittelpunkt angeordnet sind, und
die Positionen der Infrarotstrahlen-Bestrahlungsmittel gegeneinander so verschoben sind, dass ein einzelnes Infrarotstrahlen-Bestrahlungsmittel vom Typ der Aufwärtsbestrahlung sich in einer Lücke der mehreren Infrarotstrahlen-Bestrahlungsmittel vom Typ der Abwärtsbestrahlung befindet, die in regelmäßigen Abständen angeordnet sind, falls die Infrarotstrahlen-Bestrahlungsmittel von zwei Stufen direkt von oben betrachtet werden.

2. Zonenschmelzvorrichtung nach Anspruch 1, wobei die Infrarotstrahlen-Bestrahlungsmittel (21 a) vom Typ der Abwärtsbestrahlung und die Infrarotstrahlen-Bestrahlungsmittel (21 b) vom Typ der Aufwärtsbestrahlung dafür ausgelegt sind, eine unabhängige Positionskontrolle derselben zu ermöglichen.

3. Zonenschmelzvorrichtung nach Anspruch 1 oder 2, wobei das Infrarotstrahlen-Bestrahlungsmittel (21) eine Infrarotlampeneinheit ist, die einen drehbaren ellipsoiden reflektierenden Spiegel (18) umfasst, in dem eine Innenfläche als Reflektionsfläche verwendet wird und eine Infrarotlampe (20) in einem Brennpunkt derselben angeordnet ist.

4. Zonenschmelzvorrichtung nach Anspruch 1 oder 2, wobei das Infrarotstrahlen-Bestrahlungsmittel (21) ein Laseroszillator ist, der zum Emittieren eines Infrarotstrahls durch einen Laserstrahl ausgelegt ist.

5. Zonenschmelzvorrichtung nach einem der Ansprüche 1 bis 4, wobei die Infrarotstrahlen-Bestrahlungsmittel (21 a) vom Typ der Abwärtsbestrahlung und die Infrarotstrahlen-Bestrahlungsmittel (21 b) vom Typ der Aufwärtsbestrahlung mit einem Bestrahlungspositionskontrollmechanismus versehen sind, der zum unabhängigen Einstellen eines Bestrahlungswinkels und einer Bestrahlungsmenge von Infrarotstrahlen ausgelegt ist.

6. Zonenschmelzvorrichtung nach einem der Ansprüche 1 bis 5, wobei das Infrarotstrahlen-Bestrahlunüsmittel (21) mit einem horizontalen Positionskontrollmechanismus für eine horizontale Bewegung in einer Bestrahlungsrichtung von einer Position aus versehen ist, in der die Probe (12) als Mittelpunkt angeordnet ist.

7. Zonenschmelzvorrichtung nach einem der Ansprüche 1 bis 6, wobei ein Probenerwärmungsmittel (22) in Rohrform so angeordnet ist, dass eine Peripherie der Probe (12) umschlossen ist.

8. Zonenschmelzvorrichtung nach Anspruch 7, die ferner einen Positionskontrollmechanismus umfasst, der zum Steuern einer Position des Probenerwärmungsmittels (22) ausgelegt ist.

9. Zonenschmelzvorrichtung nach einem der Ansprüche 1 bis 8, wobei ein Kristallerwärmungsmittel (24) in Rohrform so angeordnet ist, dass eine Peripherie des gezüchteten Kristalls (14) umschlossen ist.

10. Zonenschmelzvorrichtung nach Anspruch 9, die ferner einen Positionskontrollmechanismus umfasst, der zum Steuern einer Position des Kristallerwärmungsmittels (24) ausgelegt ist.

11. Zonenschmelzvorrichtung nach einem der Ansprüche 1 bis 10, die ferner einen Mechanismus umfasst, bei dem ein Abschirmelement (26), welches zum Begrenzen einer Strahlungsmenge von Infrarotstrahlen ausgelegt ist, die vom Infrarotstrahlen-Bestrahlungsmittel (21) emittiert werden, um die Probe (12) und den gezüchteten Kristall (14) herum angeordnet ist und bei dem eine Synchronisierung mit einer Drehung und einer Bewegung des gezüchteten Kristalls ermöglicht wird.

12. Zonenschmelzvorrichtung nach einem der Ansprüche 1 bis 11, wobei ein Einleitungsgasrohr (34), das aus transparentem Quarz hergestellt ist, das zum effizienten Ausstoßen eines verdampften Materials, welches beim Erwärmen und Schmelzen der Probe (12) erzeugt wird, zusammen mit dem Atmosphärengas außerhalb der Probenkammer ausgelegt ist, zwischen einer Innenwand der Probenkammer und der Probe angeordnet ist.

13. Zonenschmelzvorrichtung nach Anspruch 12, wobei ein Durchmesser einer Form eines Endteils, der sich auf der Seite zum Erwärmen und Schmelzen der Probe für das Einleitungsgasrohr (34) befindet, größer als der von anderen Teilen ist.

14. Zonenschmelzvorrichtung nach Anspruch 12 oder 13, wobei ein Atmosphärengas (32) so eingeleitet werden kann, dass eine Durchflussrate des Atmosphärengases, welches durch das Einleitungsgasrohr (34) strömt, mindestens 10 cm pro Sekunde beträgt.

15. Zonenschmelzvorrichtung nach einem der Ansprüche 1 bis 14, die ferner eine Umwälzvorrichtung (36) umfasst, welche zum Zuführen eines Atmosphärengases (32), das aus der Probenkammer (30) ausgestoßen wurde, zurück in die Probenkammer ausgelegt ist, wobei die Umwälzvorrichtung vorzugsweise dafür ausgelegt ist, verdampftes Material, das beim Erwärmen und Schmelzen der Probe (12) erzeugt wird und das zusammen mit dem Atmosphärengas ausgestoßen wird, unter Verwendung eines Filterelementes (38) derart abzutrennen, dass nur das Atmosphärengas der Probenkammer zugeführt wird.

## Revendications

1. Appareil de fusion à zone flottante (10a ; 10b ; 10c ; 10d ; 10e) du type à chauffage par concentration d'infrarouges, dans lequel un échantillon (12) est placé dans une chambre à échantillon (30) constituée d'un tube de quartz transparent, un gaz atmosphérique (32) est introduit dans la chambre à échantillon, des rayons infrarouges qui sont émis par une pluralité de moyens d'irradiation de rayons infrarouges (21) sont soumis à une convergence vers l'échantillon pour chauffer et faire fondre l'échantillon dans cet état, obtenant de la sorte une solution fondue, et la solution fondue est solidifiée sur un cristal d'ensemencement pour faire croître un monocristal (14),
la pluralité de moyens d'irradiation de rayons infrarouges comprenant :
une pluralité de moyens d'irradiation de rayons infrarouges (21a) du type à irradiation vers le bas qui émet un rayon infrarouge vers le bas depuis une direction supérieure en oblique ; et
une pluralité de moyens d'irradiation de rayons infrarouges (21b) du type à irradiation vers le haut qui émet un rayon infrarouge vers le haut depuis une direction inférieure en oblique,
dans lequel la pluralité de moyens d'irradiation de rayons infrarouges (21a) du type à irradiation vers le bas et la pluralité de moyens d'irradiation de rayons infrarouges (21b) du type à irradiation vers le haut sont disposés à intervalles réguliers autour d'un axe de l'échantillon (12) comme centre, et
les positions des moyens d'irradiation de rayons infrarouges sont décalées l'une de l'autre de manière à ce qu'un seul moyen d'irradiation de rayons infrarouges du type à irradiation vers le haut soit situé dans un intervalle de la pluralité de moyens d'irradiation de rayons infrarouges du type à irradiation vers le bas disposés à intervalles réguliers dans le cas où les moyens d'irradiation de rayonnements infrarouges de deux étages sont observés directement depuis le dessus.

2. Appareil de fusion à zone flottante selon la revendication 1, dans lequel les moyens d'irradiation de rayonnements infrarouges (21a) du type à irradiation vers le bas et les moyens d'irradiation de rayons infrarouges (21b) du type à irradiation vers le haut sont configurés pour permettre leur commande de position de manière indépendante.

3. Appareil de fusion à zone flottante selon la revendication 1 ou 2, dans lequel les moyens d'irradiation de rayons infrarouges (21) sont formés d'une unité de lampe infrarouge comprenant un miroir réfléchissant ellipsoïdal rotatif (18), dans lequel une face interne est utilisée comme face réfléchissante, et une lampe infrarouge (20) disposée au niveau d'un point focal de celle-ci.

4. Appareil de fusion à zone flottante selon la revendication 1 ou 2, dans lequel les moyens d'irradiation de rayonnements infrarouges (21) sont formés d'un oscillateur laser qui est configuré pour émettre un rayon infrarouge par un faisceau laser.

5. Appareil de fusion à zone flottante selon l'une quelconque des revendications 1 à 4, dans lequel les moyens d'irradiation de rayons infrarouges (21a) du type à irradiation vers le bas et les moyens d'irradiation de rayons infrarouges (21b) du type à irradiation vers le haut sont pourvus d'un mécanisme de commande de position d'irradiation qui est configuré pour ajuster indépendamment un angle d'irradiation et une quantité d'irradiation de rayons infrarouges.

6. Appareil de fusion à zone flottante selon l'une quelconque des revendications 1 à 5, dans lequel les moyens d'irradiation de rayons infrarouges (21) sont pourvus d'un mécanisme de commande de position horizontale pour un mouvement horizontal dans une direction d'irradiation à partir d'une position dans laquelle l'échantillon (12) est disposé au centre.

7. Appareil de fusion à zone flottante selon l'une quelconque des revendications 1 à 6, dans lequel un moyen de chauffage d'échantillon (22) de forme tubulaire est disposé de manière à ce qu'une périphérie de l'échantillon (12) soit enserrée.

8. Appareil de fusion à zone flottante selon la revendication 7, comprenant en outre un mécanisme de commande de position qui est configuré pour commander une position du moyen de chauffage d'échantillon (22).

9. Appareil de fusion à zone flottante selon l'une quelconque des revendications 1 à 8, dans lequel un moyen de chauffage de cristal (24) de forme tubulaire est disposé de manière à ce qu'une périphérie du cristal en cours de croissance (14) soit enserrée.

10. Appareil de fusion à zone flottante selon la revendication 9, comprenant en outre un mécanisme de commande de position qui est configuré pour commander une position du moyen de chauffage de cristal (24).

11. Appareil de fusion à zone flottante selon l'une quelconque des revendications 1 à 10, comprenant en outre un mécanisme dans lequel un élément de protection (26), qui est configuré pour limiter une quantité d'irradiation de rayons infrarouges qui sont émis par les moyens d'irradiation de rayons infrarouges (21), est disposé autour de l'échantillon (12) et du cristal en cours de croissance (14) et dans lequel une synchronisation est activée avec une rotation et un mouvement du cristal en cours de croissance.

12. Appareil de fusion à zone flottante selon l'une quelconque des revendications 1 à 11, dans lequel un tuyau de gaz d'introduction (34) constitué de quartz transparent qui est configuré pour éjecter efficacement un matériau vaporisé qui est généré lors du chauffage et de la fusion de l'échantillon (12) conjointement avec le gaz atmosphérique à l'extérieur de la chambre d'échantillon, est disposé entre une paroi interne de la chambre à échantillon et l'échantillon.

13. Appareil de fusion à zone flottante selon la revendication 12, dans lequel un diamètre d'une forme d'une partie d'extrémité qui est située sur le côté de chauffage et de fusion de l'échantillon pour le tuyau de gaz d'introduction (34) est supérieur à celui d'autres parties.

14. Appareil de fusion à zone flottante selon la revendication 12 ou 13, dans lequel un gaz atmosphérique (32) peut être introduit de manière à ce qu'un débit d'écoulement du gaz atmosphérique qui traverse le tuyau de gaz d'introduction (34) soit d'au moins 10 cm par seconde.

15. Appareil de fusion à zone flottante selon l'une quelconque des revendications 1 à 14, comprenant en outre un dispositif de circulation (36) qui est configuré pour acheminer un gaz atmosphérique (32) qui a été éjecté de la chambre à échantillon (30) à nouveau dans la chambre à échantillon, dans lequel le dispositif de circulation est de préférence configuré pour séparer un matériau vaporisé qui est généré lors du chauffage et de la fusion de l'échantillon (12) et qui est éjecté conjointement avec le gaz atmosphérique en utilisant un élément filtrant (38) de manière à ce que seul le gaz atmosphérique soit acheminé dans la chambre à échantillon.
